# EUROPEAN PATENT APPLICATION

(11) **EP 4 486 088 A1**
(43) Date of publication of application: **01.01.2025**
(21) Application number: 24185133.6
(22) Date of filing: 27.06.2024
(51) Int. Cl.: H10K 50/13, H10K 50/19

(54) **ORGANIC ELECTROLUMINESCENT DEVICES**

(30) Priority: 27.06.2023 US 202363523432 P; 03.06.2024 US 202418731732
(71) Applicant: Universal Display Corporation, Ewing, NJ 08618 (US)
(72) Inventor: MARGULIES, Eric A., Ewing, NJ, 08618 (US); WEAVER, Michael Stuart, Ewing, NJ, 08618 (US); ADAMOVICH, Vadim, Ewing, NJ, 08618 (US); HACK, Michael, Ewing, NJ, 08618 (US)
(74) Representative: Maiwald GmbH

(57) **Abstract**

Embodiments of the disclosed subject matter provide a device including at least two stacked emissive layers. A difference in peak wavelength between the at least two stacked emissive layers may be less than or equal to 30 nm, less than or equal to 20 nm, and/or less than or equal to 10 nm. The emission output of the two emissive layers has a difference in 1976 CIE color space may be at least 0.004, at least 0.006, at least 0.008, at least 0.010, at least 0.015, at least 0.020, at least 0.025, and/or at least 0.050 Δu'v'.

## Description

### CROSS-REFERENCE TO RELATED APPLICATIONS

This application claims priority to U.S. Patent Application Serial No. 63/523,432, filed June 27, 2023, the entire contents of which are incorporated herein by reference.

### FIELD

The present invention relates to emissive devices including organic emissive devices with a plurality of stacked emissive layers, and techniques for fabricating the same.

### BACKGROUND

Opto-electronic devices that make use of organic materials are becoming increasingly desirable for a number of reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, and organic photodetectors. For OLEDs, the organic materials may have performance advantages over conventional materials. For example, the wavelength at which an organic emissive layer emits light may generally be readily tuned with appropriate dopants.

OLEDs make use of thin organic films that emit light when voltage is applied across the device. OLEDs are becoming an increasingly interesting technology for use in applications such as flat panel displays, illumination, and backlighting. Several OLED materials and configurations are described in U.S. Pat. Nos. 5,844,363, 6,303,238, and 5,707,745, which are incorporated herein by reference in their entirety.

One application for phosphorescent molecules capable of phosphorescent emission is a full color display. Industry standards for such a display call for pixels adapted to emit particular colors, referred to as "saturated" colors. In particular, these standards call for saturated red, green, and blue pixels. Alternatively, the OLED can be designed to emit white light. In conventional liquid crystal displays emission from a white backlight is filtered using absorption filters to produce red, green and blue emission. The same technique can also be used with OLEDs. The white OLED can be either a single EML device or a stack structure. Color may be measured using CIE coordinates, which are well known to the art.

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processible" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

Layers, materials, regions, and devices may be described herein in reference to the color of light they emit. In general, as used herein, an emissive region that is described as producing a specific color of light may include one or more emissive layers disposed over each other in a stack.

As used herein, a "red" layer, material, region, or device refers to one that emits light in the range of about 580-700 nm or having a highest peak in its emission spectrum in that region. Similarly, a "green" layer, material, region, or device refers to one that emits or has an emission spectrum with a peak wavelength in the range of about 500-600 nm; a "blue" layer, material, or device refers to one that emits or has an emission spectrum with a peak wavelength in the range of about 400-500nm; a "yellow" layer, material, region, or device refers to one that has an emission spectrum with a peak wavelength in the range of about 540-600 nm; a "cyan" layer, material, or device refers to one that emits or has an emission spectrum with a peak wavelength in the range of about 490-520nm; and an "orange" layer, material, or device refers to one that emits or has an emission spectrum with a peak wavelength in the range of about 570-620 nm. In some arrangements, separate regions, layers, materials, regions, or devices may provide separate "deep blue" and a "light blue" light. As used herein, in arrangements that provide separate "light blue" and "deep blue", the "deep blue" component refers to one having a peak emission wavelength that is at least about 4nm less than the peak emission wavelength of the "light blue" component. Typically, a "light blue" component has a peak emission wavelength in the range of about 465-500 nm, and a "deep blue" component has a peak emission wavelength in the range of about 400-470 nm, though these ranges may vary for some configurations. Similarly, a color altering layer refers to a layer that converts or modifies another color of light to light having a wavelength as specified for that color. For example, a "red" color filter refers to a filter that results in light having a wavelength in the range of about 580-700 nm. In general, there are two classes of color altering layers: color filters that modify a spectrum by removing unwanted wavelengths of light, and color changing layers that convert photons of higher energy to lower energy. A component "of a color" refers to a component that, when activated or used, produces or otherwise emits light having a particular color as previously described. For example, a "first emissive region of a first color" and a "second emissive region of a second color different than the first color" describes two emissive regions that, when activated within a device, emit two different colors as previously described.

As used herein, emissive materials, layers, and regions may be distinguished from one another and from other structures based upon the spectrum of light initially generated by the material, layer or region, as opposed to light eventually emitted by the same or a different structure. The initial light generation typically is the result of an energy level change resulting in emission of a photon. For example, an organic emissive material may initially generate blue light, which may be converted by a color filter, quantum dot or other structure to red or green light, such that a complete emissive stack or sub-pixel emits the red or green light. In this case the initial emissive material or layer may be referred to as a "blue" component, even though the sub-pixel is a "red" or "green" component.

In some cases, it may be preferable to describe the color of a component such as an emissive region, sub-pixel, color altering layer, or the like, in terms of 1931 CIE coordinates. For example, a yellow emissive material may have multiple peak emission wavelengths, one in or near an edge of the "green" region, and one within or near an edge of the "red" region as previously described. Accordingly, as used herein, each color term also corresponds to a shape in the 1931 CIE coordinate color space. The shape in 1931 CIE color space is constructed by following the locus between two color points and any additional interior points. For example, interior shape parameters for red, green, blue, and yellow may be defined as shown below:

| **Color** | **CIE Shape Parameters** |
|---|---|
| Central Red | Locus: [0.6270,0.3725];[0.7347,0.2653]; lnterior:[0.5086,0.2657] |
| Central Green | Locus: [0.0326,0.3530];[0.3731,0.6245]; Interior:[0.2268,0.3321 |
| Central Blue | Locus: [0.1746,0.0052];[0.0326,0.3530]; Interior:[0.2268,0.3321] |
| Central Yellow | Locus: [0.373 I,0.6245];[0.6270,0.3725]; Interior:[0.3 700,0.4087];[0.2886,0.4572] |

More details on OLEDs, and the definitions described above, can be found in US Pat. No. 7,279,704, which is incorporated herein by reference in its entirety.

### SUMMARY

According to an embodiment, an organic light emitting diode/device (OLED) is provided. The OLED can include an anode, a cathode, and an organic layer, disposed between the anode and the cathode. According to an embodiment, the organic light emitting device is incorporated into one or more device selected from a consumer product, an electronic component module, and/or a lighting panel.

According to an embodiment, a device may include at least two stacked emissive layers. A difference in peak wavelength between the at least two stacked emissive layers may be less than or equal to 30 nm, less than or equal to 20 nm, and/or less than or equal to 10 nm. The emission output of the two emissive layers may have a difference in 1976 CIE color space that at least 0.004, at least 0.006, at least 0.008, at least 0.010, at least 0.015, at least 0.020, at least 0.025, and/or at least 0.050 Δu'v'.

At least one charge generation layer may be disposed between the at least two stacked emissive layers.

The device may be a microcavity device.

The at least two stacked emissive layers may include at least two red emissive layers, at least two green emissive layers, at least two blue emissive layers, and/or at least two yellow emissive layers. The two or more emissive layers of the at least two stacked emissive layers may include different materials, and/or different hosts. The two or more emissive layers of the at least two stacked emissive layers may include different emitters. The two or more emissive layers of the at least two stacked emissive layers may include different emissive layer materials. At least one of the two of more emissive layers may include a fluorescent emitter and a phosphorescent emitter. At least one of the two or more emissive layers may include a phosphorescent emitter. At least one of the two or more emissive layers may include a delayed fluorescent emitter. At least one of the two or more emissive layers may include a non-delayed fluorescent emitter. At least two of the two of more emissive layers may include a fluorescent emitter and a phosphorescent emitter. At least two of the two or more emissive layers may include a phosphorescent emitter. At least two of the two or more emissive layers comprises a delayed fluorescent emitter. At least two of the two or more emissive layers may include a non-delayed fluorescent emitter.

Two or more emissive layers of the at least two stacked emissive layers may have a different lineshape that is at least 2 nm, at least 4 nm, at least 6 nm, and/or at least 8 nm different full width at half maximum (FWHM) or full width at quarter maximum (FWQM). At least one emissive layer of the two or more emissive layers may have a FWHM that is less than 80 nm, less than 70 nm, less than 60 nm, less than 50 nm, less than 40 nm, and/or less than 30 nm. The device may have a FWHM that is less than 60 nm, less than 50 nm, 40 nm, 30 nm, 20 nm, and/or 10 nm. At least one emissive layer of the two or more emissive layers may have a FWQM that is less than 100 nm, 90 nm, 80 nm, 70 nm, 60 nm, and/or 50 nm. The device may have a FWQM that is less than 70nm, less than 60 nm, less than 50 nm, less than 40 nm, less than 30 nm, and/or less than 20 nm. Two or more emissive layers of the at least two stacked emissive layers may have a different external quantum efficiency (EQE) that is at least 1%, at least 3%, and/or at least 5%. At least one emissive layer of the two or more emissive layers may have an EQE that is greater than 10%, greater than 20%, greater than 30%, and/or greater than 40%. At least two emissive layers of the two or more emissive layers may each have an EQE that is greater than 10%, greater than 20%, greater than 30%, and/or greater than 40%. Two or more emissive layers of the at least two stacked emissive layers may have different external quantum efficiency roll offs with a driving current density increase that is at least 1%, at least 3%, and at least 5%. At least one emissive layer of the two or more emissive layers may have a roll off that is less than 75%, less than 80%, less than 85%, and/or less than 90%. At least two emissive layers of the two or more emissive layers may each have a roll off that is less than 75%, less than 80%, less than 85%, and/or less than 90%. Two or more emissive layers of the at least two stacked emissive layers may have a lifetime that is different by at least 10%, at least 25%, and/or at least 50%. Two or more emissive layers of the at least two stacked emissive layers may have a different operating voltage at a selected current density. Two or more emissive layers of the at least two stacked emissive layers may have different doping concentrations. Two or more emissive layers of the at least two stacked emissive layers may have different thicknesses from one another by at least 50 Å, at least 100 Å, and/or at least 200 Å.

One emissive layer of the at least two stacked emissive layers may be at a first lineshape emitter, and a second lineshape emitter. One emissive layer of the at least two stacked emissive layers may be the first lineshape emitter and may be disposed closer to a reflective electrode of the device than another of the at least two stacked emissive layers. One emissive layer of the at least two stacked emissive layers may be the second lineshape emitter and is disposed closer to a reflective electrode of the device than another of the at least two stacked emissive layers.

One emissive layer of the at least two stacked emissive layers may be blue-shifted compared to another emissive layer of the at least two stacked emissive layers and is disposed closer to a reflective electrode of the device. One emissive layer of the at least two stacked emissive layers may be red-shifted compared to another emissive layer of the at least two stacked emissive layers and is disposed closer to a reflective electrode of the device.

Two or more emissive layers of the at least two stacked emissive layers have different cavity conditions.

At least one of the at least two stacked emissive layers is detuned from an optical cavity maxima determined by a maximum luminous efficacy (LE) by at least one selected from a group consisting of: 3%, 5%, 8%, or 10% LE. A closest optical maxima may be 1/4, 2/4, 1/4, 4/4, and/or 5/4 wavelength (λ). At least two of the stacked emissive layers may age differently.

Two or more emissive layers of the at least two stacked emissive layers may age differently under operating conditions, where LT95 may be 10% different, 25% different, and/or 50% different between the two or more emissive layers of the at least two stacked emissive devices.

The at least two stacked emissive layers may be at least a stack of three emissive layers, at least a stack of four emissive layers, and/or at least a stack of five emissive layers.

An angular dependence of one or more emissive layers of the at least two emissive layers may change with aging of the one or more emissive layers. A luminance amount of one or more emissive layers of the at least two stacked emissive layers changes when the angular dependence of the one or more emissive layers changes. A CIE value of one or more emissive layers of the at least two stacked emissive layers may change when the angular dependence of the one or more emissive layers changes.

There may be a different angular dependence between different emissive layers of the at least two emissive layers, where the angular dependence has a luminance that may be at least 2%, at least 4%, at least 6%, and least 8%, and/or at least 10% different, and a CIE that may be at least 0.002, at least 0.004, at least 0.006, 0.008, and 0.010 different when emitting light at 45° or 60° to a normal direction.

The device may include at least one charge generation layer that includes a metallic layer. The at least one charge generation layer may have a transparency of greater than 10%, greater than 30%, greater than 50%, and/or greater than 75%.

The at least two stacked emissive layers of the device may have different transparencies.

Two or more emissive layers of the at least two stacked emissive layers of the device may be individually addressable, and where the device having the at least two stacked emissive layers has a transparent anode and a transparent cathode.

Two or more emissive layers of the at least two stacked emissive layers are individually addressable, where the device having the at least two stacked emissive layers may have a transparent electrode and a reflecting electrode.

According to an embodiment, a device may include at least two stacked emissive layers. A difference in peak wavelength between the at least two stacked emissive layers may be less than or equal to 50 nm, less than or equal to 40 nm, less than or equal to 30 nm, less than or equal to 20 nm, and/or less than or equal to 10 nm. The different in peak wavelength between the at least two stacked emissive layers may be greater than 1 nm, greater than 2 nm, greater than 3 nm, greater than 4 nm, and/or greater than 5 nm.

According to an embodiment, a device may include at least two stacked emissive layers. The emission output of the two stacked emissive layers may have a difference in 1976 CIE color space that is at least 0.004, at least 0.006, at least 0.008, at least 0.010, at least 0.015, at least 0.020, at least 0.025, and/or at least 0.050 Δu'v'. The emission output of the two stacked emissive layers may have a difference in 1976 CIE color space that is less than 0.35, less than 0.30, less than 0.25, less than 0.20, and/or less than 0.10 Δu'v'.

According to an embodiment, a consumer electronic device may include at least two stacked emissive layers. A difference in peak wavelength between the at least two stacked emissive layers may be less than or equal to 30 nm, less than or equal to 20 nm, and/or less than or equal to 10 nm. The emission output of the two emissive layers may have a difference in 1976 CIE color space that may be at least 0.004, at least 0.006, at least 0.008, at least 0.010, at least 0.015, at least 0.020, at least 0.025, and/or at least 0.050 Δu'v'.

The consumer electronic device may be a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, an automotive display, a video walls comprising multiple displays tiled together, a theater or stadium screen, and/or a sign.

According to an embodiment, a device may include an organic light emitting device (OLED) having at least one pixel, where each pixel has one or more sub-pixels, and where at least one sub-pixel of the one or more sub-pixels may have at least two stacked emissive layers. A difference in peak wavelength between the at least two stacked emissive layers may be less than or equal to 30 nm, less than or equal to 20 nm, and/or less than or equal to 10 nm. The emission output of the two emissive layers may have a difference in 1976 CIE color space that is selected from a group consisting of: at least 0.004, at least 0.006, at least 0.008, at least 0.010, at least 0.015, at least 0.020, at least 0.025, and at least 0.050 Δu'v'.

At least one charge generation layer may be disposed between the at least two stacked emissive layers.

The device may be a microcavity device.

The at least two stacked emissive layers may include at least two red emissive layers, at least two green emissive layers, at least two blue emissive layers, and/or at least two yellow emissive layers. The two or more emissive layers of the at least two stacked emissive layers may include different materials, and/or different hosts. The two or more emissive layers of the at least two stacked emissive layers may include different emitters. The two or more emissive layers of the at least two stacked emissive layers may include different emissive layer materials. At least one of the two of more emissive layers may include a fluorescent emitter and a phosphorescent emitter. At least one of the two or more emissive layers may include a phosphorescent emitter. At least one of the two or more emissive layers may include a delayed fluorescent emitter. At least one of the two or more emissive layers may include a non-delayed fluorescent emitter. At least two of the two of more emissive layers may include a fluorescent emitter and a phosphorescent emitter. At least two of the two or more emissive layers may include a phosphorescent emitter. At least two of the two or more emissive layers comprises a delayed fluorescent emitter. At least two of the two or more emissive layers may include a non-delayed fluorescent emitter.

Two or more emissive layers of the at least two stacked emissive layers may have a different lineshape that is at least 2 nm, at least 4 nm, at least 6 nm, and/or at least 8 nm different full width at half maximum (FWHM) or full width at quarter maximum (FWQM). At least one emissive layer of the two or more emissive layers may have a FWHM that is less than 80 nm, less than 70 nm, less than 60 nm, less than 50 nm, less than 40 nm, and/or less than 30 nm. The device may have a FWHM that is less than 60 nm, less than 50 nm, 40 nm, 30 nm, 20 nm, and/or 10 nm. At least one emissive layer of the two or more emissive layers may have a FWQM that is less than 100 nm, 90 nm, 80 nm, 70 nm, 60 nm, and/or 50 nm. The device may have a FWQM that is less than 70nm, less than 60 nm, less than 50 nm, less than 40 nm, less than 30 nm, and/or less than 20 nm. Two or more emissive layers of the at least two stacked emissive layers may have a different external quantum efficiency (EQE) that is at least 1%, at least 3%, and/or at least 5%. At least one emissive layer of the two or more emissive layers may have an EQE that is greater than 10%, greater than 20%, greater than 30%, and/or greater than 40%. At least two emissive layers of the two or more emissive layers may each have an EQE that is greater than 10%, greater than 20%, greater than 30%, and/or greater than 40%. Two or more emissive layers of the at least two stacked emissive layers may have different external quantum efficiency roll offs with a driving current density increase that is at least 1%, at least 3%, and at least 5%. At least one emissive layer of the two or more emissive layers may have a roll off that is less than 75%, less than 80%, less than 85%, and/or less than 90%. At least two emissive layers of the two or more emissive layers may each have a roll off that is less than 75%, less than 80%, less than 85%, and/or less than 90%. Two or more emissive layers of the at least two stacked emissive layers may have a lifetime that is different by at least 10%, at least 25%, and/or at least 50%. Two or more emissive layers of the at least two stacked emissive layers may have a different operating voltage at a selected current density. Two or more emissive layers of the at least two stacked emissive layers may have different doping concentrations. Two or more emissive layers of the at least two stacked emissive layers may have different thicknesses from one another by at least 50 Å, at least 100 Å, and/or at least 200 Å.

One emissive layer of the at least two stacked emissive layers may be at a first lineshape emitter, and a second lineshape emitter. One emissive layer of the at least two stacked emissive layers may be the first lineshape emitter and may be disposed closer to a reflective electrode of the device than another of the at least two stacked emissive layers. One emissive layer of the at least two stacked emissive layers may be the second lineshape emitter and is disposed closer to a reflective electrode of the device than another of the at least two stacked emissive layers.

One emissive layer of the at least two stacked emissive layers may be blue-shifted compared to another emissive layer of the at least two stacked emissive layers and is disposed closer to a reflective electrode of the device. One emissive layer of the at least two stacked emissive layers may be red-shifted compared to another emissive layer of the at least two stacked emissive layers and is disposed closer to a reflective electrode of the device.

Two or more emissive layers of the at least two stacked emissive layers have different cavity conditions.

At least one of the at least two stacked emissive layers is detuned from an optical cavity maxima determined by a maximum luminous efficacy (LE) by at least one selected from a group consisting of: 3%, 5%, 8%, or 10% LE. A closest optical maxima may be 1/4, 2/4, 1/4, 4/4, and/or 5/4 wavelength (?). At least two of the stacked emissive layers may age differentlydifferentially.

Two or more emissive layers of the at least two stacked emissive layers may age differently under operating conditions, where LT95 may be 10% different, 25% different, and/or 50% different between the two or more emissive layers of the at least two stacked emissive devices.

The at least two stacked emissive layers may be at least a stack of three emissive layers, at least a stack of four emissive layers, and/or at least a stack of five emissive layers.

An angular dependence of one or more emissive layers of the at least two emissive layers may change with aging of the one or more emissive layers. A luminance amount of one or more emissive layers of the at least two stacked emissive layers changes when the angular dependence of the one or more emissive layers changes. A CIE value of one or more emissive layers of the at least two stacked emissive layers may change when the angular dependence of the one or more emissive layers changes.

There may be a different angular dependence between different emissive layers of the at least two emissive layers, where the angular dependence has a luminance that may be at least 2%, at least 4%, at least 6%, and least 8%, and/or at least 10% different, and a CIE that may be at least 0.002, at least 0.004, at least 0.006, 0.008, and 0.010 different when emitting light at 45° or 60° to a normal direction.

The device may include at least one charge generation layer that includes a metallic layer. The at least one charge generation layer may have a transparency of greater than 10%, greater than 30%, greater than 50%, and/or greater than 75%.

The at least two stacked emissive layers of the device may have different transparencies.

Two or more emissive layers of the at least two stacked emissive layers of the device may be individually addressable, and where the device having the at least two stacked emissive layers has a transparent anode and a transparent cathode.

Two or more emissive layers of the at least two stacked emissive layers are individually addressable, where the device having the at least two stacked emissive layers may have a transparent electrode and a reflecting electrode.

### BRIEF DESCRIPTION OF THE DRAWINGS

FIG. 1 shows an organic light emitting device.
FIG. 2 shows an inverted organic light emitting device that does not have a separate electron transport layer.
FIG. 3 shows an example device having at least two stacked emissive layers according to implementations of the disclosed subject matter.

### DETAILED DESCRIPTION

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

The initial OLEDs used emissive molecules that emitted light from their singlet states ("fluorescence") as disclosed, for example, in U.S. Pat. No. 4,769,292, which is incorporated by reference in its entirety. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electro phosphorescence," Appl. Phys. Lett., vol. 75, No. 3, 4-6 (1999) ("Baldo-II"), are incorporated by reference in their entireties. Phosphorescence is described in more detail in US Pat. No. 7,279,704 at cols. 5-6, which are incorporated by reference.

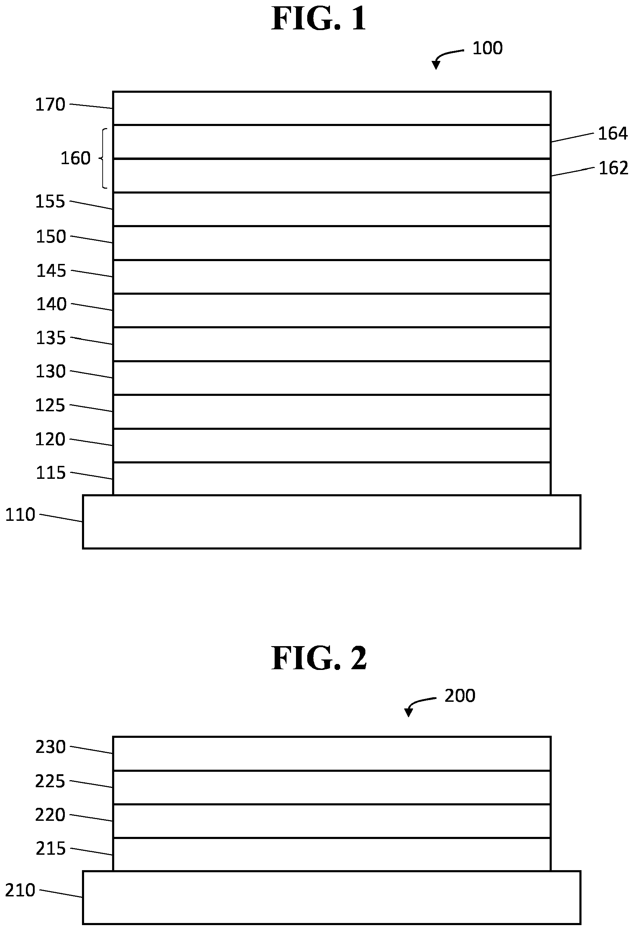

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10, which are incorporated by reference.

More examples for each of these layers are available. For example, a flexible and transparent substrate-anode combination is disclosed in U.S. Pat. No. 5,844,363, which is incorporated by reference in its entirety. An example of a p-doped hole transport layer is m-MTDATA doped with F₄-TCNQ at a molar ratio of 50:1, as disclosed in U.S. Patent Application Publication No. 2003/0230980, which is incorporated by reference in its entirety. Examples of emissive and host materials are disclosed in U.S. Pat. No. 6,303,238 to Thompson et al., which is incorporated by reference in its entirety. An example of an n-doped electron transport layer is BPhen doped with Li at a molar ratio of 1:1, as disclosed in U.S. Patent Application Publication No. 2003/0230980, which is incorporated by reference in its entirety. U.S. Pat. Nos. 5,703,436 and 5,707,745, which are incorporated by reference in their entireties, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980, which are incorporated by reference in their entireties. Examples of injection layers are provided in U.S. Patent Application Publication No. 2004/0174116, which is incorporated by reference in its entirety. Barrier layer 170 may be a single- or multi-layer barrier and may cover or surround the other layers of the device. The barrier layer 170 may also surround the substrate 110, and/or it may be arranged between the substrate and the other layers of the device. The barrier also may be referred to as an encapsulant, encapsulation layer, protective layer, or permeation barrier, and typically provides protection against permeation by moisture, ambient air, and other similar materials through to the other layers of the device. Examples of barrier layer materials and structures are provided in U.S. Patent Nos. 6,537,688, 6,597,111, 6,664,137, 6,835,950, 6,888,305, 6,888,307, 6,897,474, 7,187,119, and 7,683,534, each of which is incorporated by reference in its entirety.

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the invention may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al., which is incorporated by reference in its entirety. By way of further example, OLEDs having a single organic layer may be used. OLEDs may be stacked, for example as described in U.S. Pat. No. 5,707,745 to Forrest et al, which is incorporated by reference in its entirety. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al., which are incorporated by reference in their entireties.

In some embodiments disclosed herein, emissive layers or materials, such as emissive layer 135 and emissive layer 220 shown in FIGS. 1-2, respectively, may include quantum dots. The emissive layer may use different emissive display technologies. Such technologies may include inorganic and /or organic devices, such as LEDs, mini LEDs, microLEDs, thin electroluminescent films, organic light emitting devices, and the like. An "emissive layer" or "emissive material" as disclosed herein may include an organic emissive material and/or an emissive material that contains quantum dots or equivalent structures, unless indicated to the contrary explicitly or by context according to the understanding of one of skill in the art. In general, an emissive layer includes emissive material within a host matrix. Such an emissive layer may include only a quantum dot material which converts light emitted by a separate emissive material or other emitter, or it may also include the separate emissive material or other emitter, or it may emit light itself directly from the application of an electric current. Similarly, a color altering layer, color filter, upconversion, or downconversion layer or structure may include a material containing quantum dots, though such layer may not be considered an "emissive layer" as disclosed herein. In general, an "emissive layer" or material is one that emits an initial light based on an injected electrical charge, where the initial light may be altered by another layer such as a color filter or other color altering layer that does not itself emit an initial light within the device, but may re-emit altered light of a different spectra content based upon absorption of the initial light emitted by the emissive layer and downconversion to a lower energy light emission. In some embodiments disclosed herein, the color altering layer, color filter, upconversion, and/or downconversion layer may be disposed outside of an OLED device, such as above or below an electrode of the OLED device.

Unless otherwise specified, any of the layers of the various embodiments may be placed, disposed, or deposited by any suitable method. For the organic layers, preferred methods include thermal evaporation, ink-jet, such as described in U.S. Pat. Nos. 6,013,982 and 6,087,196, which are incorporated by reference in their entireties, organic vapor phase deposition (OVPD), such as described in U.S. Pat. No. 6,337,102 to Forrest et al., which is incorporated by reference in its entirety, and deposition by organic vapor jet printing (OVJP), such as described in U.S. Pat. No. 7,431,968, which is incorporated by reference in its entirety. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, which are incorporated by reference in their entireties, and patterning associated with some of the deposition methods such as ink-jet and OVJD. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processibility than those having symmetric structures, because asymmetric materials may have a lower tendency to recrystallize. Dendrimer substituents may be used to enhance the ability of small molecules to undergo solution processing.

Devices fabricated in accordance with embodiments of the present invention may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829, which are herein incorporated by reference in their entireties. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

In some embodiments, at least one of the anode, the cathode, or a new layer disposed over the organic emissive layer functions as an enhancement layer. The enhancement layer comprises a plasmonic material exhibiting surface plasmon resonance that non-radiatively couples to the emitter material and transfers excited state energy from the emitter material to non-radiative mode of surface plasmon polariton. The enhancement layer is provided no more than a threshold distance away from the organic emissive layer, where the emitter material has a total non-radiative decay rate constant and a total radiative decay rate constant due to the presence of the enhancement layer and the threshold distance is where the total non-radiative decay rate constant is equal to the total radiative decay rate constant. In some embodiments, the OLED further comprises an outcoupling layer. In some embodiments, the outcoupling layer is disposed over the enhancement layer on the opposite side of the organic emissive layer. In some embodiments, the outcoupling layer is disposed on opposite side of the emissive layer from the enhancement layer but still outcouples energy from the surface plasmon mode of the enhancement layer. The outcoupling layer scatters the energy from the surface plasmon polaritons. In some embodiments this energy is scattered as photons to free space. In other embodiments, the energy is scattered from the surface plasmon mode into other modes of the device such as but not limited to the organic waveguide mode, the substrate mode, or another waveguiding mode. If energy is scattered to the non-free space mode of the OLED other outcoupling schemes could be incorporated to extract that energy to free space. In some embodiments, one or more intervening layer can be disposed between the enhancement layer and the outcoupling layer. The examples for intervening layer(s) can be dielectric materials, including organic, inorganic, perovskites, oxides, and may include stacks and/or mixtures of these materials.

The enhancement layer modifies the effective properties of the medium in which the emitter material resides resulting in any or all of the following: a decreased rate of emission, a modification of emission line-shape, a change in emission intensity with angle, a change in the stability of the emitter material, a change in the efficiency of the OLED, and reduced efficiency roll-off of the OLED device. Placement of the enhancement layer on the cathode side, anode side, or on both sides results in OLED devices which take advantage of any of the above-mentioned effects. In addition to the specific functional layers mentioned herein and illustrated in the various OLED examples shown in the figures, the OLEDs according to the present disclosure may include any of the other functional layers often found in OLEDs.

The enhancement layer can be comprised of plasmonic materials, optically active metamaterials, or hyperbolic metamaterials. As used herein, a plasmonic material is a material in which the real part of the dielectric constant crosses zero in the visible or ultraviolet region of the electromagnetic spectrum. In some embodiments, the plasmonic material includes at least one metal. In such embodiments the metal may include at least one of Ag, Al, Au, Ir, Pt, Ni, Cu, W, Ta, Fe, Cr, Mg, Ga, Rh, Ti, Ru, Pd, In, Bi, Ca alloys or mixtures of these materials, and stacks of these materials. In general, a metamaterial is a medium composed of different materials where the medium as a whole acts differently than the sum of its material parts. In particular, we define optically active metamaterials as materials which have both negative permittivity and negative permeability. Hyperbolic metamaterials, on the other hand, are anisotropic media in which the permittivity or permeability are of different sign for different spatial directions. Optically active metamaterials and hyperbolic metamaterials are strictly distinguished from many other photonic structures such as Distributed Bragg Reflectors ("DBRs") in that the medium should appear uniform in the direction of propagation on the length scale of the wavelength of light. Using terminology that one skilled in the art can understand: the dielectric constant of the metamaterials in the direction of propagation can be described with the effective medium approximation. Plasmonic materials and metamaterials provide methods for controlling the propagation of light that can enhance OLED performance in a number of ways.

In some embodiments, the enhancement layer is provided as a planar layer. In other embodiments, the enhancement layer has wavelength-sized features that are arranged periodically, quasi-periodically, or randomly, or sub-wavelength-sized features that are arranged periodically, quasi-periodically, or randomly. In some embodiments, the wavelength-sized features and the sub-wavelength-sized features have sharp edges.

In some embodiments, the outcoupling layer has wavelength-sized features that are arranged periodically, quasi-periodically, or randomly, or sub-wavelength-sized features that are arranged periodically, quasi-periodically, or randomly. In some embodiments, the outcoupling layer may be composed of a plurality of nanoparticles and in other embodiments the outcoupling layer is composed of a plurality of nanoparticles disposed over a material. In these embodiments the outcoupling may be tunable by at least one of varying a size of the plurality of nanoparticles, varying a shape of the plurality of nanoparticles, changing a material of the plurality of nanoparticles, adjusting a thickness of the material, changing the refractive index of the material or an additional layer disposed on the plurality of nanoparticles, varying a thickness of the enhancement layer, and/or varying the material of the enhancement layer. The plurality of nanoparticles of the device may be formed from at least one of metal, dielectric material, semiconductor materials, an alloy of metal, a mixture of dielectric materials, a stack or layering of one or more materials, and/or a core of one type of material and that is coated with a shell of a different type of material. In some embodiments, the outcoupling layer is composed of at least metal nanoparticles where the metal is selected from the group consisting of Ag, Al, Au, Ir, Pt, Ni, Cu, W, Ta, Fe, Cr, Mg, Ga, Rh, Ti, Ru, Pd, In, Bi, Ca, alloys or mixtures of these materials, and stacks of these materials. The plurality of nanoparticles may have additional layer disposed over them. In some embodiments, the polarization of the emission can be tuned using the outcoupling layer. Varying the dimensionality and periodicity of the outcoupling layer can select a type of polarization that is preferentially outcoupled to air. In some embodiments the outcoupling layer also acts as an electrode of the device.

In embodiments of the disclosed subject matter, a device may include an enhancement layer that is disposed over an emissive area of at least one sub-pixel that is configured to have a Lambertian emission and/or at least one sub-pixel having a microcavity configured for direct emission, as described in detail below. In at least some of such embodiments, the enhancement layer may include a plasmonic structure that is disposed a predetermined threshold distance from the emissive area. The predetermined threshold distance may be a distance at which a total non-radiative decay rate constant is equal to a total radiative decay rate constant. In some of such embodiments, device may include an outcoupling layer is disposed over the enhancement layer on the opposite side of the emissive area.

It is believed that the internal quantum efficiency (IQE) of fluorescent OLEDs can exceed the 25% spin statistics limit through delayed fluorescence. As used herein, there are two types of delayed fluorescence, i.e., P-type delayed fluorescence and E-type delayed fluorescence. P-type delayed fluorescence is generated from triplet-triplet annihilation (TTA).

In some embodiments, a compound in an emissive material and/or layer in an OLED may be used as a phosphorescent sensitizer, where one or multiple layers in the OLED may include an acceptor in the form of one or more fluorescent and/or delayed fluorescence emitters. In some embodiments, the compound can be used as one component of an exciplex to be used as a sensitizer. As a phosphorescent sensitizer, the compound may be capable of energy transfer to the acceptor, and the acceptor may emit the energy or further transfer energy to a final emitter. The acceptor concentrations may range from 0.001% to 100%. The acceptor may be in either the same layer as the phosphorescent sensitizer or in one or more different layers. In some embodiments, the acceptor may be a TADF emitter. In some embodiments, the acceptor may be a fluorescent emitter. In some embodiments, the emission may arise from any or all of the sensitizer, acceptor, and/or final emitter.

On the other hand, E-type delayed fluorescence described above does not rely on the collision of two triplets, but rather on the thermal population between the triplet states and the singlet excited states. Compounds that are capable of generating E-type delayed fluorescence are required to have very small singlet-triplet gaps. Thermal energy can activate the transition from the triplet state back to the singlet state. This type of delayed fluorescence is also known as thermally activated delayed fluorescence (TADF). A distinctive feature of TADF is that the delayed component increases as temperature rises due to the increased thermal energy. If the reverse intersystem crossing rate is fast enough to minimize the non-radiative decay from the triplet state, the fraction of back populated singlet excited states can potentially reach 75%. The total singlet fraction can be 100%, far exceeding the spin statistics limit for electrically generated excitons.

E-type delayed fluorescence characteristics can be found in an exciplex system or in a single compound. Without being bound by theory, it is believed that E-type delayed fluorescence requires the luminescent material to have a small singlet-triplet energy gap (ΔES-T). Organic, non-metal containing, donor-acceptor luminescent materials may be able to achieve this. The emission in these materials is often characterized as a donor-acceptor charge-transfer (CT) type emission. The spatial separation of the HOMO and LUMO in these donor-acceptor type compounds often results in small ΔES-T. These states may involve CT states. Often, donor-acceptor luminescent materials are constructed by connecting an electron donor moiety such as amino- or carbazole-derivatives and an electron acceptor moiety such as N-containing six-membered aromatic ring.

Devices fabricated in accordance with embodiments of the invention can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the invention can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, an automotive display, a video walls comprising multiple displays tiled together, a theater or stadium screen, and a sign. Various control mechanisms may be used to control devices fabricated in accordance with the present invention, including passive matrix and active matrix. Many of the devices are intended for use in a temperature range comfortable to humans, such as 18 C to 30 C, and more preferably at room temperature (20-25 C), but could be used outside this temperature range, for example, from - 40 C to 80 C.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

In some embodiments, the OLED has one or more characteristics selected from the group consisting of being flexible, being rollable, being foldable, being stretchable, and being curved. In some embodiments, the OLED is transparent or semi-transparent. In some embodiments, the OLED further comprises a layer having carbon nanotubes.

In some embodiments, the OLED further comprises a layer having a delayed fluorescent emitter. In some embodiments, the OLED comprises a RGB pixel arrangement or white plus color filter pixel arrangement. In some embodiments, the OLED is a mobile device, a hand held device, or a wearable device. In some embodiments, the OLED is a display panel having less than 10 inch diagonal or 50 square inch area. In some embodiments, the OLED is a display panel having at least 10 inch diagonal or 50 square inch area. In some embodiments, the OLED is a lighting panel.

In some embodiments of the emissive region, the emissive region further comprises a host.

In some embodiments, the compound causing light to be generated can be an emissive dopant. In some embodiments, the compound can produce emissions via phosphorescence, fluorescence, thermally activated delayed fluorescence, i.e., TADF (also referred to as E-type delayed fluorescence), triplet-triplet annihilation, or combinations of these processes, including phosphor sensitized fluorescence.

The OLED disclosed herein can be incorporated into one or more of a consumer product, an electronic component module, and a lighting panel. The organic layer can be an emissive layer and the compound can be an emissive dopant in some embodiments, while the compound can be a non-emissive dopant in other embodiments.

The organic layer can also include a host. In some embodiments, two or more hosts are preferred. In some embodiments, the hosts used maybe a) bipolar, b) electron transporting, c) hole transporting or d) wide band gap materials that play little role in charge transport. In some embodiments, the host can include a metal complex. The host can be an inorganic compound.

### COMBINATION WITH OTHER MATERIALS

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

Various materials may be used for the various emissive and non-emissive layers and arrangements disclosed herein. Examples of suitable materials are disclosed in U.S. Patent Application Publication No. 2017/0229663, which is incorporated by reference in its entirety.

### Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer.

### HIL/HTL:

A hole injecting/transporting material to be used in the present invention is not particularly limited, and any compound may be used as long as the compound is typically used as a hole injecting/transporting material.

### EBL:

An electron blocking layer (EBL) may be used to reduce the number of electrons and/or excitons that leave the emissive layer. The presence of such a blocking layer in a device may result in substantially higher efficiencies, and or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than the emitter closest to the EBL interface. In some embodiments, the EBL material has a higher LUMO (closer to the vacuum level) and or higher triplet energy than one or more of the hosts closest to the EBL interface. In one aspect, the compound used in EBL contains the same molecule or the same functional groups used as one of the hosts described below.

### Host:

The light emitting layer of the organic EL device of the present invention preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. Any host material may be used with any dopant so long as the triplet criteria is satisfied.

### HBL:

A hole blocking layer (HBL) may be used to reduce the number of holes and/or excitons that leave the emissive layer. The presence of such a blocking layer in a device may result in substantially higher efFiciencies and/or longer lifetime as compared to a similar device lacking a blocking layer. Also, a blocking layer may be used to confine emission to a desired region of an OLED. In some embodiments, the HBL material has a lower HOMO (further from the vacuum level) and or higher triplet energy than the emitter closest to the HBL interface. In some embodiments, the HBL material has a lower HOMO (further from the vacuum level) and or higher triplet energy than one or more of the hosts closest to the HBL interface.

### ETL:

An electron transport layer (ETL) may include a material capable of transporting electrons. The electron transport layer may be intrinsic (undoped), or doped. Doping may be used to enhance conductivity. Examples of the ETL material are not particularly limited, and any metal complexes or organic compounds may be used as long as they are typically used to transport electrons.

### Charge generation layer (CGL)

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

The use of two or more stacked pixels of the same primary color may provide higher brightness at the same current density and longer device lifetime at a given luminance for display applications where these are important factors. These stacked devices may have additional design variables which may be optimized for advantages unique to these devices. Embodiments of the disclosed subject matter may optimize these types of monochrome stacked OLEDs.

Independently optimizing each OLED within a stacked device may provide advantages in performance and/or manufacturability for stacked monochromatic OLEDs. Some of the benefits of optimizing these two or more EMLs/cavities independently may include increased manufacturing tolerances, decreased color shift as a function of viewing angle both for monochromatic colors and white (e.g., where white may be derived from the combined emission from different color sub-pixels), decreased luminance shift as a function of viewing angle, increased color pixel color saturation, increased pixel efficiency, decreased color shift as a function of aging, less luminance loss as function of aging, increased and/or decreased angular dependance as a function of aging, and/or improved coupling to a quantum dot and/or other downconversion layer and/or color filter. In some embodiments, reflectivity from a bottom electrode may be reduced, which may increase contrast ratio especially for a polarizer free device. When the stacks are configured to be individually addressable, the device transparency may be changed by selecting different devices.

Embodiments of the disclosed subject matter optimize a plurality of emitters. The optimization may be different for different emissive layers within a stack (e.g., a monochromatic stack). The cavity observed by an emitter may change with respect to the position of the emitter within the OLED, and/or the position of the emitter relative to the electrode interfaces (e.g., cavity node positions). An emission spectrum of an emitter may be optimized with respect to the positioning with a cavity and/or stacked OLED may be different depending on the location.

By using different emitters in different stacks to emit monochromatic light from an OLED, angle dependance may be minimized. Color saturation may be balanced with efficiency and/or efficacy. Arrangements may balance color with aging, maximize efficiency for a given required output color, and/or minimize a drive voltage.

Emitters used within a stack may include different types of OLED emitters, such as phosphorescent, fluorescent, thermally activated delayed fluorescence (TADF), sensitized OLEDs, and the like.

The location of each emissive layer within optical cavity may be optimized. For example, forward-facing efficiency may be maximized. A cavity may be separately tuned for separate emitters. For example, a first emissive layer may have a cavity tuned to maximize forward facing luminous efficacy, and a second emissive layer may be off the maximum to optimize another parameter. One or more cavities may be tuned for angle dependence. In some embodiments, there may be different de-tuning of one or more emissive layer locations. In some embodiments, angular dependance of luminance and/or CIE shift (i.e., shift in the CIE 1931 color space) may be minimized. One or more emissive layers may be disposed at different cavity resonances, such as between ¼ wavelength (λ), ½ λ, ¾ λ, and/or 5/4 λ. In some embodiments, the reflection from a bottom electrode may be reduced. Implementations may provide improved coupling to downconversion films, downconversion layers, and/or color filters.

In some embodiments, emitter doping may be optimized. For example, there may be a different color emitter for one or more emissive layers, and/or each emissive layer. In some embodiments, there may be a different balance of emission from one or more emissive layers, and/or each emissive layer. Differential aging may be optimized to compensate aging color shift.

In some embodiments, the host choice may be optimized. For example, a different host and/or host composition may be used for different emissive layers and/or each emissive layer in the OLED stack. In some embodiments, different emissive layer thicknesses may be used for the emissive layers and/or each emissive layer in the OLED stack. The host may be selected to optimize the impact on aging, such as with color shift and the like.

In some embodiments, a blocking layer may be selected to optimize the stacked arrangement. Different blocking layers may be used for different emissive layers and/or each emissive layer in the OLED stack. Different blocking layer thicknesses may be used for different emissive layers and/or for each emissive layer in the OLED stack.

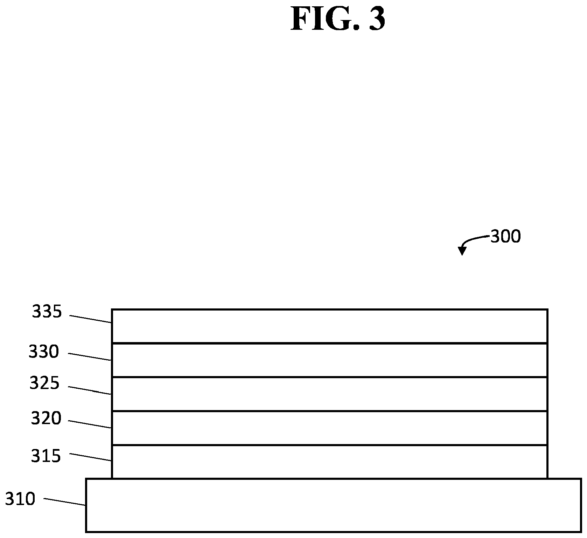

FIG. 3 shows an example device 300 having at least two stacked emissive layers according to implementations of the disclosed subject matter. Device 300 may include substrate 310, anode 315, a first emissive layer 320, a charge generation layer 325, a second emissive layer 330, and a cathode 335.

The device 300 may be an organic light emitting device (OLED) having at least two stacked emissive layers (e.g., first emissive layer 320 and second emissive layer 330). Although two stacked layers are shown in FIG. 3, there may be more than two emissive layers that may be stacked. For example, the at least two stacked emissive layers may be at least a stack of three emissive layers, at least a stack of four emissive layers, and/or at least a stack of five emissive layers. In some embodiments, the OLED of the device 300 may be a microcavity device.

A difference in peak wavelength between the at least two stacked emissive layers may be less than or euqal to 50 nm, less than or equal to 40 nm, less than or equal to 30 nm, less than or equal to 20 nm, and/or less than or equal to 10 nm. The emission output of the two emissive layers may have a difference in 1976 CIE color space that is at least 0.004, at least 0.006, at least 0.008, at least 0.010, at least 0.015, at least 0.020, at least 0.025, and at least 0.050 Δu'v'.

At least one charge generation layer (e.g., charge generation layer 325) may be disposed between the at least two stacked emissive layers. For example, as shown in FIG. 3, charge generation layer 325 may be disposed between the first emissive layer 320 and the second emissive layer 330. In some embodiments, the charge generation layer 325 may be an electrode.

The at least two stacked emissive layers (e.g., first emissive layer 320 and second emissive layer 330 shown in FIG. 3) may include at least two red emissive layers, at least two green emissive layers, at least two blue emissive layers, and/or at least two yellow emissive layers.

The two or more emissive layers of the at least two stacked emissive layers may include different materials and/or different hosts. In some embodiments, the different emitters may be chemically different from one another.

The two or more emissive layers of the at least two stacked emissive layers may include different emitters. The two or more emissive layers of the at least two stacked emissive layers may include different emissive layer materials. The different emissive materials may be fluorescent materials, phosphorescent materials, quantum dots, and the like. For example, at least one of the two of more emissive layers may include a fluorescent emitter and a phosphorescent emitter. In another example, at least one of the two or more emissive layers may include a phosphorescent emitter. In another example, at least one of the two or more emissive layers may include a delayed fluorescent emitter. In yet another example, at least one of the two or more emissive layers may include a non-delayed fluorescent emitter. In a further example, at least two of the two of more emissive layers may include a fluorescent emitter and a phosphorescent emitter. In another example, at least two of the two or more emissive layers may include a phosphorescent emitter. In another example, at least two of the two or more emissive layers comprises a delayed fluorescent emitter. In yet another example, at least two of the two or more emissive layers may include a non-delayed fluorescent emitter.

In some embodiments, two or more emissive layers of the at least two stacked emissive layers (e.g., first emissive layer 320 and second emissive layer 330 shown in FIG. 3) may have a different lineshape. That is, the two or more emissive layers may have any type of different in lineshape between them. For example, the two or more emissive layers may have a different lineshape that is at least 2 nm, at least 4 nm, at least 6 nm, and/or at least 8 nm different full width at half maximum (FWHM) or full width at quarter maximum (FWQM). For example, at least one emissive layer of the two or more emissive layers may have a FWHM that is less than 80nm, less than 70 nm, less than 60 nm, less than 50 nm, less than 40 nm, and/or less than 30 nm. In another example, the device may have a FWHM that is less than 60 nm, less than 50 nm, 40 nm, 30 nm, 20 nm, and/or 10 nm. In another example at least one emissive layer of the two or more emissive layers may have a FWQM that is less than 100 nm, 90 nm, 80 nm, 70 nm, 60 nm, and/or 50 nm. In yet another example, the device may have a FWQM that is less than 70nm, less than 60 nm, less than 50 nm, less than 40 nm, less than 30 nm, and/or less than 20 nm.

One emissive layer of the at least two stacked emissive layers may be at a first lineshape emitter and/or a second lineshape emitter. For example, the first emissive layer 320 may have a first lineshape that is a broader lineshape, and a second emissive layer 330 may have a second lineshape that may be a narrower lineshape. There may be any difference in lineshape between the first lineshape and second lineshape emitters. The broader lineshape may be based on M/T, having a broader full width quarter maximum (FWQM), and/or full width half maximum (FWHM). Similarly, the narrower in the spec based on M/T, having a narrower full width quarter maximum (FWQM), and/or full width half maximum (FWHM). In some embodiments, lineshape may be defined primarily by M/T, secondarily by FWQM, and then by FWHM. M/T may be defined as an integral of a main (M) peak (e.g., +/-15 nm, or 10 nm, or 70 meV, or the like) divided by the integral of a total spectrum.

In some embodiments, one emissive layer of the at least two stacked emissive layers (e.g., first emissive layer 320 and second emissive layer 330 shown in FIG. 3) may be the first lineshape emitter (e.g., that emits the broader lineshape) and may be disposed closer to a reflective electrode (e.g., anode 315 and/or cathode 335) of the OLED than another of the at least two stacked emissive layers. One emissive layer of the at least two stacked emissive layers may be the second lineshape emitter (e.g., that emits the narrower lineshape) and is disposed closer to a reflective electrode of the OLED than another of the at least two stacked emissive layers.

In some embodiments, two or more emissive layers of the at least two stacked emissive layers may have a different external quantum efficiency (EQE) that is at least 1%, at least 3%, and/or at least 5%. In one example, at least one emissive layer of the two or more emissive layers may have an EQE that is greater than 10%, greater than 20%, greater than 30%, and/or greater than 40%. In another example, at least two emissive layers of the two or more emissive layers may each have an EQE that is greater than 10%, greater than 20%, greater than 30%, and/or greater than 40%. The two or more emissive layers of the at least two stacked emissive layers may have different EQE roll offs with a current density increase that is at least 1%, at least 3%, and/or at least 5%. EQE roll off may be defined as device EQE at 10 mA/cm² divided by the device EQE at 1 mA/cm². In one example, two or more emissive layers of the at least two stacked emissive layers may have different external quantum efficiency roll offs with a driving current density increase that is at least 1%, at least 3%, and at least 5%. In another example, at least one emissive layer of the two or more emissive layers may have a roll off that is less than 75%, less than 80%, less than 85%, and/or less than 90%. In another example, at least two emissive layers of the two or more emissive layers may each have a roll off that is less than 75%, less than 80%, less than 85%, and/or less than 90%. The two or more emissive layers of the at least two stacked emissive layers may have a lifetime that is different by at least 10%, at least 25%, and/or at least 50%. Two or more emissive layers of the at least two stacked emissive layers may have a different operating voltage at a selected current density or at a selected luminance. For example, a selected current density may be 10 mA/cm2, 40 mA/cm², 80 mA/cm², and the like.

Two or more emissive layers of the at least two stacked emissive layers (e.g., first emissive layer 320 and second emissive layer 330) may have different doping concentrations. Two or more emissive layers of the at least two stacked emissive layers may have different thicknesses from one another. For example, the thicknesses may differ by at least 50 Å, at least 100 Å, and/or at least 200 Å.

In some embodiments, one emissive layer of the at least two stacked emissive layers may be blue-shifted compared to another emissive layer of the at least two stacked emissive layers (e.g., first emissive layer 320 and/or second emissive layer 330 show in FIG. 3) and is disposed closer to a reflective electrode (e.g., anode 315 and/or cathode 335 shown in FIG. 3) of the OLED. One emissive layer of the at least two stacked emissive layers may be red-shifted compared to another emissive layer of the at least two stacked emissive layers and is disposed closer to a reflective electrode of the OLED.

Two or more emissive layers of the at least two stacked emissive layers have different cavity conditions. That is, the two or more emissive layers may not be at the same place in a luminous efficacy (LE) vs. CIE x (of the CIE 1931 color space) curve. LE is a measure of how well a light source produces visible light, and is the ratio of luminous flux to power (measured in lumens per watt). At least one of the at least two stacked emissive layers is detuned from an optical cavity maxima determined by a maximum LE by at least one selected from a group consisting of: 3%, 5%, 8%, or 10% LE. A closest optical maxima may be 1/4, 2/4, 1/4, 4/4, and/or 5/4 wavelength (λ).

At least two of the stacked emissive layers may age differently. In some embodiments, two or more emissive layers of the at least two stacked emissive layers may age differently under operating conditions, where LT95 may be 10% different, 25% different, and/or 50% different between the two or more emissive layers of the at least two stacked emissive devices. LT95 may be a 5% reduction in brightness from the initial brightness (100%). An angular dependence of one or more emissive layers of the at least two emissive layers may change with aging of the one or more emissive layers. A luminance amount of one or more emissive layers of the at least two stacked emissive layers changes when the angular dependence of the one or more emissive layers changes. A CIE value of one or more emissive layers of the at least two stacked emissive layers may change when the angular dependence of the one or more emissive layers changes.

There may be a different angular dependence between different emissive layers of the at least two emissive layers. For example, the angular dependence may have a luminance that may be at least 2%, at least 4%, at least 6%, and least 8%, and/or at least 10% different, and a CIE that may be at least 0.002, at least 0.004, at least 0.006, 0.008, and 0.010 different when emitting light at 45° or 60° to a normal direction.

The device may include at least one charge generation layer (e.g., charge generation layer 325 as shown in FIG. 3) that includes a metallic layer. The at least one charge generation layer may have a transparency of greater than 10%, greater than 30%, greater than 50%, and/or greater than 75%. In some embodiments, the at least two stacked emissive layers (e.g., first emissive layer 320 and/or second emissive layer 330 shown in FIG. 3) of the device may have different transparencies. Two or more emissive layers of the at least two stacked emissive layers (e.g., first emissive layer 320 and/or second emissive layer 330 shown in FIG. 3) of the device may be individually addressable and that have a transparent anode (e.g., anode 315 shown in FIG. 3) and a transparent cathode (e.g., cathode 335 shown in FIG. 3). In some embodiments, two or more emissive layers of the at least two stacked emissive layers are individually addressable, where the device having the at least two stacked emissive layers may have a transparent electrode (e.g., anode 315 and/or cathode 335) and a reflecting electrode (e.g., anode 315 and/or cathode 335).

According to an embodiment, a device (e.g., device 300 shown in FIG. 3) may include an organic light emitting device (OLED) having at least two stacked emissive layers (e.g., first emissive layer 320 and second emissive layer 330). A difference in peak wavelength between the at least two stacked emissive layers may be, for example, less than or equal to 50 nm, less than or equal to 40 nm, less than or equal to 30 nm, less than or equal to 20 nm, and/or less than or equal to 10 nm. The different in peak wavelength between the at least two stacked emissive layers may be, for example, greater than 1 nm, greater than 2 nm, greater than 3 nm, greater than 4 nm, and/or greater than 5 nm.

According to an embodiment, a device (e.g., device 300 shown in FIG. 3) may include an organic light emitting device (OLED) having at least two stacked emissive layers (e.g., first emissive layer 320 and second emissive layer 330 show in FIG. 3). The emission output of the two stacked emissive layers may have a difference in 1976 CIE color space that is, for example, at least 0.004, at least 0.006, at least 0.008, at least 0.010, at least 0.015, at least 0.020, at least 0.025, and/or at least 0.050 Δu'v'. The emission output of the two stacked emissive layers may have a difference in 1976 CIE color space that is, for example, less than 0.35, less than 0.30, less than 0.25, less than 0.20, and/or less than 0.10 Δu'v'.

According to an embodiment, a consumer electronic device (e.g., device 300 shown in FIG. 3) may include an organic light emitting device (OLED) having at least two stacked emissive layers (e.g., first emissive layer 320 and second emissive layer 330 show in FIG. 3). A difference in peak wavelength between the at least two stacked emissive layers may be less than or equal to 30 nm, less than or equal to 20 nm, and/or less than or equal to 10 nm. The emission output of the two emissive layers may have a difference in 1976 CIE color space that may be at least 0.004, at least 0.006, at least 0.008, at least 0.010, at least 0.015, at least 0.020, at least 0.025, and/or at least 0.050 Δu'v'.

In one embodiment, a device may include an organic light emitting device (OLED) having at least one pixel, where each pixel has one or more sub-pixels, and where at least one sub-pixel of the one or more sub-pixels may have at least two stacked emissive layers. A difference in peak wavelength between the at least two stacked emissive layers may be less than or equal to 30 nm, less than or equal to 20 nm, and/or less than or equal to 10 nm. The emission output of the two emissive layers may have a difference in 1976 CIE color space that is selected from a group consisting of: at least 0.004, at least 0.006, at least 0.008, at least 0.010, at least 0.015, at least 0.020, at least 0.025, and at least 0.050 Δu'v'.

A device of one or more of the disclose embodiments may be a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, an automotive display, a video walls comprising multiple displays tiled together, a theater or stadium screen, and/or a sign.

The Following examples are provided:
Example 1. A device comprising:
   at least two stacked emissive layers,
   wherein a difference in peak wavelength between the at least two stacked emissive layers is at least one selected from a group consisting of: less than or equal to 30 nm, less than or equal to 20 nm, and less than or equal to 10 nm, and
   wherein the emission output of the two emissive layers has a difference in 1976 CIE color space that is selected from a group consisting of: at least 0.004, at least 0.006, at least 0.008, at least 0.010, at least 0.015, at least 0.020, at least 0.025, and at least 0.050 Δu'v'.
Example 2. The device of Example 1, further comprising at least one charge generation layer disposed between the at least two stacked emissive layers.
Example 3. The device of any of Examples 1-2, wherein the device is a microcavity device.
Example 4. The device of any of Examples 1-3, wherein the at least two stacked emissive layers include a selection from a group consisting of: at least two red emissive layers, at least two green emissive layers, at least two blue emissive layers, and at least two yellow emissive layers.
Example 5. The device of any of Examples 1-4, wherein two or more emissive layers of the at least two stacked emissive layers are comprised of at least one selected from a group consisting of: different materials, and different hosts.
Example 6. The device of any of Examples 1-5, wherein the two or more emissive layers of the at least two stacked emissive layers are comprised of different emitters.
Example 7. The device of any of Examples 1-6, wherein the two or more emissive layers of the at least two stacked emissive layers are comprised of different emissive layer materials.
Example 8. The device of Example 7, wherein at least one of the two of more emissive layers comprises a fluorescent emitter and a phosphorescent emitter.
Example 9. The device of any of Examples 7-8, wherein at least one of the two or more emissive layers comprises a phosphorescent emitter.
Example 10. The device of any of Examples 7-9, wherein at least one of the two or more emissive layers comprises a delayed fluorescent emitter.
Example 11. The device of any of Examples 7-10, wherein at least one of the two or more emissive layers comprises a non-delayed fluorescent emitter.
Example 12. The device of any of Examples 7-11, wherein at least two of the two of more emissive layers comprises a fluorescent emitter and a phosphorescent emitter.
Example 13. The device of any of Examples 7-12, wherein at least two of the two or more emissive layers comprises a phosphorescent emitter.
Example 14. The device of any of Examples 7-13, wherein at least two of the two or more emissive layers comprises a delayed fluorescent emitter.
Example 15. The device of any of Examples 7-14, wherein at least two of the two or more emissive layers comprises a non-delayed fluorescent emitter.
Example 16. The device of any of Examples 1-15, wherein two or more emissive layers of the at least two stacked emissive layers have a different lineshape that is selected from a group consisting of: at least 2 nm, at least 4 nm, at least 6 nm, and at least 8 nm different full width at half maximum (FWHM) or full width at quarter maximum (FWQM).
Example 17. The device of Example 16, wherein at least one emissive layer of the two or more emissive layers has a FWHM selected from the group consisting of: less than 80 nm, less than 70 nm, less than 60 nm, less than 50 nm, less than 40 nm, and less than 30 nm.
Example 18. The device of any of Examples 16-17, wherein the device has a FWHM selected from the group consisting of: less than 60 nm, less than 50 nm, less than 40 nm, less than 30 nm, less than 20 nm, and less than 10 nm.
Example 19. The device of any of Examples 16-18, wherein at least one emissive layer of the two or more emissive layers has a FWQM selected from the group consisting of: less than 100 nm, less than 90 nm, less than 80 nm, less than 70nm, less than 60 nm, and less than 50 nm.
Example 20. The device of any of Examples 16-19, wherein the device has a FWQM selected from the group consisting of: less than 70 nm, less than 60 nm, less than 50 nm, less than 40 nm, less than 30 nm, and less than 20 nm.
Example 21. The device of any of Examples 1-20, wherein two or more emissive layers of the at least two stacked emissive layers have a different external quantum efficiency (EQE) that is selected from the group consisting of: at least 1%, at least 3%, and at least 5%.
Example 22. The device of Example 21, wherein at least one emissive layer of the two or more emissive layers has an EQE selected from the group consisting of: greater than 10%, greater than 20%, greater than 30%, and greater than 40%.
Example 23. The device of any of Examples 21-22, wherein at least two emissive layers of the two or more emissive layers each have an EQE selected from the group consisting of: greater than 10%, greater than 20%, greater than 30%, or greater than 40%.
Example 24. The device of any of Examples 1-23, wherein two or more emissive layers of the at least two stacked emissive layers have different external quantum efficiency roll offs with a driving current density increase that is selected from the group consisting of: at least 1%, at least 3%, and at least 5%.
Example 25. The device of Example 24, wherein at least one emissive layer of the two or more emissive layers has a roll off selected from the group consisting of: less than 75%, less than 80%, less than 85%, or less than 90%.
Example 26. The device of any of Examples 24-25, wherein at least two emissive layers of the two or more emissive layers each have a roll off selected from the group consisting of: less than 75%, less than 80%, less than 85%, or less than 90%.
Example 27. The device of any of Examples 1-26, wherein two or more emissive layers of the at least two stacked emissive layers have a lifetime that is different by at least one selected from the group consisting of: at least 10%, at least 25%, and at least 50%.
Example 28. The device of any of Examples 1-27, wherein two or more emissive layers of the at least two stacked emissive layers have a different operating voltage at a selected current density.
Example 29. The device of any of Examples 1-28, wherein two or more emissive layers of the at least two stacked emissive layers have different doping concentrations.
Example 30. The device of any of Examples 1-29, wherein two or more emissive layers of the at least two stacked emissive layers have different thicknesses from one another by at least one selected from the group consisting of: at least 50 Å, at least 100 Å, and at least 200 Å.
Example 31. The device of any of Examples 1-30, wherein one emissive layer of the at least two stacked emissive layers is at least one selected from the group consisting of: a first lineshape emitter, and a second lineshape emitter.
Example 32. The device of Example 31, wherein one emissive layer of the at least two stacked emissive layers is the first lineshape emitter and is disposed closer to a reflective electrode of the device than another of the at least two stacked emissive layers.
Example 33. The device of any of Examples 31-32, wherein one emissive layer of the at least two stacked emissive layers is the second lineshape emitter and is disposed closer to a reflective electrode of the device than another of the at least two stacked emissive layers.
Example 34. The device of any of Examples 1-33, wherein one emissive layer of the at least two stacked emissive layers is blue-shifted compared to another emissive layer of the at least two stacked emissive layers and is disposed closer to a reflective electrode of the device.
Example 35. The device of any of Examples 1-34, wherein one emissive layer of the at least two stacked emissive layers is red-shifted compared to another emissive layer of the at least two stacked emissive layers and is disposed closer to a reflective electrode of the device.
Example 36. The device of any of Examples 1-35, wherein two or more emissive layers of the at least two stacked emissive layers have different cavity conditions.
Example 37. The device of any of Examples 1-36, wherein at least one of the at least two stacked emissive layers is detuned from an optical cavity maxima determined by a maximum luminous efficacy (LE) by at least one selected from a group consisting of: 3%, 5%, 8%, or 10% LE.
Example 38. The device of Example 37, wherein a closest optical maxima is at least one selected from a group consisting of: 1/4, 2/4, 1/4, 4/4, 5/4 wavelength (λ).
Example 39. The device of any of Examples 37-38, wherein at least two of the stacked emissive layers age differently.
Example 40. The device of any of Examples 1-39, wherein two or more emissive layers of the at least two stacked emissive layers age differently under operating conditions, where LT95 is at least one selected from the group consisting of: 10% different, 25% different, and 50% different between the two or more emissive layers of the at least two stacked emissive devices.
Example 41. The device of any of Examples 1-40, wherein the at least two stacked emissive layers comprises at least one selected from the group consisting of: at least a stack of three emissive layers, at least a stack of four emissive layers, and at least a stack of five emissive layers.
Example 42. The device of any of Examples 1-41, wherein an angular dependence of one or more emissive layers of the at least two emissive layers changes with aging of the one or more emissive layers.
Example 43. The device of Example 42, wherein a luminance amount of one or more emissive layers of the at least two stacked emissive layers changes when the angular dependence of the one or more emissive layers changes.
Example 44. The device of any of Examples 42-43, wherein a CIE value of one or more emissive layers of the at least two stacked emissive layers changes when the angular dependence of the one or more emissive layers changes.
Example 45. The device of any of Examples 1-43, wherein there is a different angular dependence between different emissive layers of the at least two emissive layers, wherein the angular dependence has a luminance that is at least one selected from a group consisting of: at least 2%, at least 4%, at least 6%, and least 8%, and at least 10% different, and a CIE that is at least one selected from a group consisting of: at least 0.002, at least 0.004, at least 0.006, 0.008, and 0.010 different when emitting light at 45° or 60° to a normal direction.
Example 46. A device comprising:
   at least two stacked emissive layers,
   wherein a difference in peak wavelength between the at least two stacked emissive layers is at least one selected from the group consisting of: less than or equal to 50 nm, less than or equal to 40 nm, less than or equal to 30 nm, less than or equal to 20 nm, and less than or equal to 10 nm, and
   wherein the different in peak wavelength between the at least two stacked emissive layers is at least one selected from the group consisting of: greater than 1 nm, greater than 2 nm, greater than 3 nm, greater than 4 nm, and greater than 5 nm.
Example 47. A device comprising:
   at least two stacked emissive layers,
   wherein the emission output of the two stacked emissive layers has a difference in 1976 CIE color space that is selected from the group consisting of: at least 0.004, at least 0.006, at least 0.008, at least 0.010, at least 0.015, at least 0.020, at least 0.025, and at least 0.050 Δu'v', and
   wherein the emission output of the two stacked emissive layers has a difference in 1976 CIE color space that is selected from the group consisting of: less than 0.35, less than 0.30, less than 0.25, less than 0.20, and less than 0.10 Δu'v'.
Example 48. A consumer electronic device comprising:
   at least two stacked emissive layers,
   wherein a difference in peak wavelength between the at least two stacked emissive layers is at least one selected from a group consisting of: less than or equal to 30 nm, less than or equal to 20 nm, and less than or equal to 10 nm, and
   wherein the emission output of the two emissive layers has a difference in 1976 CIE color space that is selected from a group consisting of: at least 0.004, at least 0.006, at least 0.008, at least 0.010, at least 0.015, at least 0.020, at least 0.025, and at least 0.050 Δu'v'.
Example 49. The consumer electronic device of Example 48, wherein the device is at least one type selected from the group consisting of: a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, an automotive display, a video walls comprising multiple displays tiled together, a theater or stadium screen, and a sign.
Example 50. A device comprising:
   an organic light emitting device (OLED) comprising at least one pixel, wherein each pixel comprises one or more sub-pixels, and wherein at least one sub-pixel of the one or more sub-pixels comprises:
   at least two stacked emissive layers,
   wherein a difference in peak wavelength between the at least two stacked emissive layers is at least one selected from a group consisting of: less than or equal to 30 nm, less than or equal to 20 nm, and less than or equal to 10 nm, and
   wherein the emission output of the two emissive layers has a difference in 1976 CIE color space that is selected from a group consisting of: at least 0.004, at least 0.006, at least 0.008, at least 0.010, at least 0.015, at least 0.020, at least 0.025, and at least 0.050 Δu'v'.
Example 51. The device of Example 50, further comprising at least one charge generation layer disposed between the at least two stacked emissive layers.
Example 52. The device of any of Examples 50-51, wherein the device is a microcavity device.
Example 53. The device of any of Examples 50-52, wherein the at least two stacked emissive layers include a selection from a group consisting of: at least two red emissive layers, at least two green emissive layers, at least two blue emissive layers, and at least two yellow emissive layers.
Example 54. The device of any of Examples 50-53, wherein two or more emissive layers of the at least two stacked emissive layers are comprised of at least one selected from a group consisting of: different materials, and different hosts.
Example 55. The device of any of Examples 50-54, wherein the two or more emissive layers of the at least two stacked emissive layers are comprised of different emitters.
Example 56. The device of any of Examples 50-55, wherein the two or more emissive layers of the at least two stacked emissive layers are comprised of different emissive layer materials.
Example 57. The device of Example 56, wherein at least one of the two of more emissive layers comprises a fluorescent emitter and a phosphorescent emitter.
Example 58. The device of any of Examples 56-57, wherein at least one of the two or more emissive layers comprises a phosphorescent emitter.
Example 59. The device of any of Examples 56-58, wherein at least one of the two or more emissive layers comprises a delayed fluorescent emitter.
Example 60. The device of any of Examples 56-59, wherein at least one of the two or more emissive layers comprises a non-delayed fluorescent emitter.
Example 61. The device of any of Examples 56-60, wherein at least two of the two of more emissive layers comprises a fluorescent emitter and a phosphorescent emitter.
Example 62. The device of any of Examples 56-61, wherein at least two of the two or more emissive layers comprises a phosphorescent emitter.
Example 63. The device of any of Examples 56-61, wherein at least two of the two or more emissive layers comprises a delayed fluorescent emitter.
Example 64. The device of any of Examples 56-63, wherein at least two of the two or more emissive layers comprises a non-delayed fluorescent emitter.
Example 65. The device of any of Examples 1-64, wherein two or more emissive layers of the at least two stacked emissive layers have a different lineshape that is selected from a group consisting of: at least 2 nm, at least 4 nm, at least 6 nm, and at least 8 nm different full width at half maximum (FWHM) or full width at quarter maximum (FWQM).
Example 66. The device of Example 65, wherein at least one emissive layer of the two or more emissive layers has a FWHM selected from the group consisting of: less than 80 nm, less than 70 nm, less than 60 nm, less than 50 nm, less than 40 nm, and less than 30 nm.
Example 67. The device of any of Examples 65-66, wherein the device has a FWHM selected from the group consisting of: less than 60 nm, less than 50 nm, less than 40 nm, less than 30 nm, less than 20 nm, and less than 10 nm.
Example 68. The device of any of Examples 65-67, wherein at least one emissive layer of the two or more emissive layers has a FWQM selected from the group consisting of: less than 100 nm, less than 90 nm, less than 80 nm, less than 70nm, less than 60 nm, and less than 50 nm.
Example 69. The device of any of Examples 65-68, wherein the device has a FWQM selected from the group consisting of: less than 70 nm, less than 60 nm, less than 50 nm, less than 40 nm, less than 30 nm, and less than 20 nm.
Example 70. The device of any of Examples 50-69, wherein two or more emissive layers of the at least two stacked emissive layers have a different external quantum efficiency (EQE) that is selected from the group consisting of: at least 1%, at least 3%, and at least 5%.
Example 71. The device of Example 70, wherein at least one emissive layer of the two or more emissive layers has an EQE selected from the group consisting of: greater than 10%, greater than 20%, greater than 30%, and greater than 40%.
Example 72. The device of any of Examples 70-71, wherein at least two emissive layers of the two or more emissive layers each have an EQE selected from the group consisting of: greater than 10%, greater than 20%, greater than 30%, or greater than 40%.
Example 73. The device of any of Examples 50-72, wherein two or more emissive layers of the at least two stacked emissive layers have different external quantum efficiency roll offs with a driving current density increase that is selected from the group consisting of: at least 1%, at least 3%, and at least 5%.
Example 74. The device of Example 73, wherein at least one emissive layer of the two or more emissive layers has a roll off selected from the group consisting of: less than 75%, less than 80%, less than 85%, or less than 90%.
Example 75. The device of any of Examples 73-74, wherein at least two emissive layers of the two or more emissive layers each have a roll off selected from the group consisting of: less than 75%, less than 80%, less than 85%, or less than 90%.
Example 76. The device of any of Examples 50-75, wherein two or more emissive layers of the at least two stacked emissive layers have a lifetime that is different by at least one selected from the group consisting of: at least 10%, at least 25%, and at least 50%.
Example 77. The device of any of Examples 50-76, wherein two or more emissive layers of the at least two stacked emissive layers have a different operating voltage at a selected current density.
Example 78. The device of any of Examples 50-77, wherein two or more emissive layers of the at least two stacked emissive layers have different doping concentrations.
Example 79. The device of any of Examples 50-78, wherein two or more emissive layers of the at least two stacked emissive layers have different thicknesses from one another by at least one selected from the group consisting of: at least 50 Å, at least 100 Å, and at least 200 Å.
Example 80. The device of any of Examples 50-79, wherein one emissive layer of the at least two stacked emissive layers is at least one selected from the group consisting of: a first lineshape emitter, and a second lineshape emitter.
Example 81. The device of Example 80, wherein one emissive layer of the at least two stacked emissive layers is the first lineshape emitter and is disposed closer to a reflective electrode of the device than another of the at least two stacked emissive layers.
Example 82. The device of Example 81, wherein one emissive layer of the at least two stacked emissive layers is the second lineshape emitter and is disposed closer to a reflective electrode of the device than another of the at least two stacked emissive layers.
Example 83. The device of any of Examples 50-82, wherein one emissive layer of the at least two stacked emissive layers is blue-shifted compared to another emissive layer of the at least two stacked emissive layers and is disposed closer to a reflective electrode of the device.
Example 84. The device of any of Examples 50-83, wherein one emissive layer of the at least two stacked emissive layers is red-shifted compared to another emissive layer of the at least two stacked emissive layers and is disposed closer to a reflective electrode of the device.
Example 85. The device of any of Examples 50-84, wherein two or more emissive layers of the at least two stacked emissive layers have different cavity conditions.
Example 86. The device of any of Examples 50-85, wherein at least one of the at least two stacked emissive layers is detuned from an optical cavity maxima determined by a maximum luminous efficacy (LE) by at least one selected from a group consisting of: 3%, 5%, 8%, or 10% LE.
Example 87. The device of Example 86, wherein a closest optical maxima is at least one selected from a group consisting of: 1/4, 2/4, 1/4, 4/4, 5/4 wavelength (λ).
Example 88. The device of Example 87, wherein at least two of the stacked emissive layers age differently.
Example 89. The device of any of Examples 50-88, wherein two or more emissive layers of the at least two stacked emissive layers age differently under operating conditions, where LT95 is at least one selected from the group consisting of: 10% different, 25% different, and 50% different between the two or more emissive layers of the at least two stacked emissive devices.
Example 90. The device of any of Examples 50-89, wherein the at least two stacked emissive layers comprises at least one selected from the group consisting of: at least a stack of three emissive layers, at least a stack of four emissive layers, and at least a stack of five emissive layers.
Example 91. The device of any of Examples 50-90, wherein an angular dependence of one or more emissive layers of the at least two emissive layers changes with aging of the one or more emissive layers.
Example 92. The device of Example 91, wherein a luminance amount of one or more emissive layers of the at least two stacked emissive layers changes when the angular dependence of the one or more emissive layers changes.
Example 93. The device of any of Examples 91-92, wherein a CIE value of one or more emissive layers of the at least two stacked emissive layers changes when the angular dependence of the one or more emissive layers changes.
Example 94. The device of any of Examples 50-93, wherein there is a different angular dependence between different emissive layers of the at least two emissive layers, wherein the angular dependence has a luminance that is at least one selected from a group consisting of: at least 2%, at least 4%, at least 6%, and least 8%, and at least 10% different, and a CIE that is at least one selected from a group consisting of: at least 0.002, at least 0.004, at least 0.006, 0.008, and 0.010 different when emitting light at 45° or 60° to a normal direction.

It is understood that the various embodiments described herein are by way of example only, and are not intended to limit the scope of the invention. For example, many of the materials and structures described herein may be substituted with other materials and structures without deviating from the spirit of the invention. The present invention as claimed may therefore include variations from the particular examples and preferred embodiments described herein, as will be apparent to one of skill in the art. It is understood that various theories as to why the invention works are not intended to be limiting.

## Claims

1. A device comprising:
at least two stacked emissive layers,
wherein a difference in peak wavelength between the at least two stacked emissive layers is at least one selected from a group consisting of: less than or equal to 30 nm, less than or equal to 20 nm, and less than or equal to 10 nm, and
wherein the emission output of the two emissive layers has a difference in 1976 CIE color space that is selected from a group consisting of: at least 0.004, at least 0.006, at least 0.008, at least 0.010, at least 0.015, at least 0.020, at least 0.025, and at least 0.050 Δu'v'.

2. The device of claim 1, further comprising at least one charge generation layer disposed between the at least two stacked emissive layers.

3. The device of any of claims 1-2, wherein the at least two stacked emissive layers include a selection from a group consisting of: at least two red emissive layers, at least two green emissive layers, at least two blue emissive layers, and at least two yellow emissive layers.

4. The device of any of claims 1-3, wherein two or more emissive layers of the at least two stacked emissive layers are comprised of at least one selected from a group consisting of: different materials, and different hosts.

5. The device of any of claims 1-4, wherein the two or more emissive layers of the at least two stacked emissive layers are comprised of different emitters.

6. The device of any of claims 1-5, wherein the two or more emissive layers of the at least two stacked emissive layers are comprised of different emissive layer materials.

7. The device of any of claims 1-6, wherein two or more emissive layers of the at least two stacked emissive layers have a different lineshape that is selected from a group consisting of: at least 2 nm, at least 4 nm, at least 6 nm, and at least 8 nm different full width at half maximum (FWHM) or full width at quarter maximum (FWQM).

8. The device of any of claims 1-7, wherein one emissive layer of the at least two stacked emissive layers is at least one selected from the group consisting of: a first lineshape emitter, and a second lineshape emitter.

9. The device of claim 8, wherein one emissive layer of the at least two stacked emissive layers is the first lineshape emitter and is disposed closer to a reflective electrode of the device than another of the at least two stacked emissive layers.

10. The device of any of claims 8-9, wherein one emissive layer of the at least two stacked emissive layers is the second lineshape emitter and is disposed closer to a reflective electrode of the device than another of the at least two stacked emissive layers.

11. The device of any of claims 1-10, wherein one emissive layer of the at least two stacked emissive layers is blue-shifted compared to another emissive layer of the at least two stacked emissive layers and is disposed closer to a reflective electrode of the device.

12. The device of any of claims 1-11, wherein one emissive layer of the at least two stacked emissive layers is red-shifted compared to another emissive layer of the at least two stacked emissive layers and is disposed closer to a reflective electrode of the device.

13. The device of any of claims 1-12, wherein the at least two stacked emissive layers comprises at least one selected from the group consisting of: at least a stack of three emissive layers, at least a stack of four emissive layers, and at least a stack of five emissive layers.

14. The device of any of claims 1-13, wherein there is a different angular dependence between different emissive layers of the at least two emissive layers, wherein the angular dependence has a luminance that is at least one selected from a group consisting of: at least 2%, at least 4%, at least 6%, and least 8%, and at least 10% different, and a CIE that is at least one selected from a group consisting of: at least 0.002, at least 0.004, at least 0.006, 0.008, and 0.010 different when emitting light at 45° or 60° to a normal direction.

15. The device of any of claims 1-14, wherein the device is at least one type selected from the group consisting of: a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, an automotive display, a video walls comprising multiple displays tiled together, a theater or stadium screen, and a sign.
